# EUROPÄISCHE PATENTANMELDUNG

(11) **EP 2 028 453 A1**
(43) Veröffentlichungstag der Anmeldung: **25.02.2009**
(21) Anmeldenummer: 07016388.6
(22) Anmeldetag: 21.08.2007
(51) Int. Cl.: G01D 5/48, H03K 17/97, B60K 37/06

(54) **Schaltersystem**

(71) Anmelder: Delphi Technologies, Inc., Troy, Michigan 48007 (US)
(72) Erfinder: Hombach, Frank, 51674 Wiehl (DE); Hupertz, Stefan, 57462 Olpe (DE); Noll, Diethelm, 57589 Birkenbeul (DE)
(74) Vertreter: Manitz, Finsterwald & Partner GbR

(57) **Zusammenfassung**

Ein Schaltersystem insbesondere für Fahrzeuge umfasst wenigstens einen Transponder, wenigstens eine Lesespule und ein mit der Lesespule verbundenes elektronisches Steuergerät. Der Transponder ist über ein zugeordnetes Betätigungselement in den Bereich der Lesespule bewegbar. Bei in den Bereich der Lesespule bewegtem Transponder werden von diesem ausgesandte Daten über die Lesespule vom Steuergerät empfangen, um über das Steuergerät in Abhängigkeit von den empfangenen Daten wenigstens ein Steuer- und/oder Regelsignal zu erzeugen.

## Beschreibung

Die Erfindung betrifft ein Schaltersystem insbesondere für Fahrzeuge.

Herkömmliche Schalter für den Einsatz auf einer Leiterplatte sind beispielsweise mechanisch aufgebaut. So sind beispielsweise auf Leiterplatten gelötete Schalter oder Carbonpillen bekannt, die über einen Stößel eine elektrische Verbindung zwischen zwei Kontakten herstellen. Hierbei bereitet jedoch der mechanische Verschleiß des Schalters und der Leiterplatte Probleme.

Bei einer aus der DE 42 38 167 A1 bekannten Schaltungsanordnung zur Identifizierung einer geschlossenen Schalterschleife, die bezüglich einer Zweidrahtleitung parallel zu einer Vielzahl von offenen Schalterschleifen liegt, enthält jede Schalterschleife einen codierten Signalgeber, der im Schließzustand des zugeordneten Schalters ein Identifikationssignal auf die Zweidrahtleitung gibt, das von einem an die Zweidrahtleitung angekoppelten Empfänger ausgewertet wird.

In der DE 199 19 158 A1 ist ein drahtloses Schalterdetektionssystem mit einem Zentralsender und einem von diesem beabstandeten Schalter beschrieben, bei dem eine über das Sendesignal des Zentralsenders mit Energie versorgte Kennzeichnungsschaltung den Zustand des Schalters detektiert und ein Kennzeichnungssignal liefert, das den Zustand des Schalters anzeigt.

Bei einer aus der US 7 006 014 B1 bekannten drahtlosen Tastatur sind den Tasten passive Transponder zugeordnet, die für den Empfang von Energie über eine Antenne selektiv zugeschaltet werden und im gedrückten Zustand einer betreffenden Taste eine codierte Antwort an ein Lesegerät liefern.

Der Erfindung liegt die Aufgabe zugrunde, ein verbessertes, insbesondere für Fahrzeuge geeignetes Schaltersystem zu schaffen, durch das die bisher üblichen mechanischen Schalter ersetzt werden können, um insbesondere einen mechanischen Verschleiß zu vermeiden.

Diese Erfindung wird erfindungsgemäß gelöst durch ein Schaltersystem insbesondere für Fahrzeuge, mit wenigstens einem Transponder, wenigstens einer Lesespule und einem mit der Lesespule verbundenen elektronischen Steuergerät, wobei der Transponder über ein zugeordnetes Betätigungselement in den Bereich der Lesespule bewegbar ist und bei in den Bereich der Lesespule bewegtem Transponder von diesem ausgesandte Daten über die Lesespule vom Steuergerät empfangen werden, um über das Steuergerät in Abhängigkeit von den empfangenen Daten wenigstens ein Steuer- und/oder Regelsignal zu erzeugen.

Aufgrund dieser Ausbildung wird ein einfaches und zuverlässiges Schaltersystem geschaffen, das insbesondere einen verschleißfreien Betrieb gewährleistet.

Bevorzugt ist einem jeweiligen Transponder eine ihm eigene Kennung zugeordnet, die über die Lesespule vom Steuergerät auslesbar ist, und über das Steuergerät auf den Empfang der Kennung hin ein zugeordnetes Steuer- bzw. Regelsignal erzeugbar.

Gemäß einer bevorzugten praktischen Ausführungsform des erfindungsgemäßen Schaltersystems sind mehrere Transponder vorgesehen, denen unterschiedliche Kennungen zugeordnet sind, wobei über das Steuergerät je nach empfangener Kennung unterschiedliche Steuer- bzw. Regelsignale erzeugbar sind.

Vorteilhafterweise ist über ein jeweiliges durch das Steuergerät erzeugtes Steuer- bzw. Regelsignal eine betreffende Schaltfunktion auslösbar oder aufhebbar.

Dabei können insbesondere mehrere Transponder vorgesehen sein, denen unterschiedliche Kennungen zugeordnet sind, wobei über das Steuergerät je nach empfangener Kennung unterschiedliche Schaltfunktionen auslösbar bzw. aufhebbar sind.

Das Betätigungselement kann an einem Träger verstellbar, insbesondere verschiebbar gelagert sein. Bevorzugt umfasst das Betätigungselement einen insbesondere aus Kunststoff bestehenden Stößel. Dabei kann der Transponder insbesondere in dem zugeordneten Stößel angeordnet sein.

Die Lesespule kann auf einer mit dem Steuergerät verbundenen Leiterplatte angeordnet sein.

Das Steuergerät kann insbesondere einen Mikrocontroller oder dergleichen umfassen.

Einer jeweiligen Lesespule können insbesondere auch mehrere Transponder mit jeweils zugeordnetem Betätigungselement zugeordnet sein.

Es ist insbesondere auch eine solche Ausführung denkbar, bei der mehrere Lesespulen vorgesehen sind, denen jeweils wenigstens ein Transponder mit zugeordnetem Betätigungselement zugeordnet ist.

Bei einer bevorzugten praktischen Ausführungsform des erfindungsgemäßen Schaltersystems ist wenigstens ein passiver Transponder vorgesehen.

Ein solcher passiver Transponder besitzt keine eigene Stromversorgung. Die erforderliche Energieversorgung erfolgt vielmehr über die Lesespule. Dabei wird durch das über diese Lesespule erzeugte elektromagnetische Feld in der Antenne des Transponders eine entsprechende Spannung bzw. ein entsprechender Strom induziert.

Grundsätzlich kann jedoch auch wenigstens ein aktiver Transponder mit eigener Stromversorgung vorgesehen sein.

Das erfindungsgemäße Schaltersystem ist insbesondere in einem Fahrzeug, und mit besonderem Vorteil insbesondere in Verbindung mit einem elektronischen Dachmodul oder einer Mittelkonsole des Fahrzeugs verwendbar.

Mit der erfindungsgemäßen Lösung können die bisher üblichen mechanischen Schalter also durch ein System aus Transponder und Lesespulen ersetzt werden. Dabei können die Transponder beispielsweise in Kunststoffstößeln angeordnet sein, die durch eine entsprechende Betätigung in ein von einer oder mehreren Lesespulen erzeugtes elektromagnetisches Feld geschoben werden. Aufgrund von unterschiedlichen Kennungen der Transponder kann beispielsweise über einen Mikrocontroller entschieden werden, welcher Schalter bzw. welches Betätigungselement betätigt wurde. Ein besonders vorteilhaftes Einsatzgebiet für diese erfindungsgemäße Technologie sind beispielsweise elektronische Dachmodule oder Mittelkonsolen von Fahrzeugen.

Die Erfindung wird im Folgenden anhand eines Ausführungsbeispiels unter Bezugnahme auf die Zeichnung näher erläutert.

Die einzige Figur der Zeichnung zeigt in schematischer Darstellung eine beispielhafte Ausführungsform eines Schaltersystems 10 insbesondere für Fahrzeuge, durch das die bisher üblichen, insbesondere auf Leiterplatten angeordneten mechanischen Schalter ersetzt werden können.

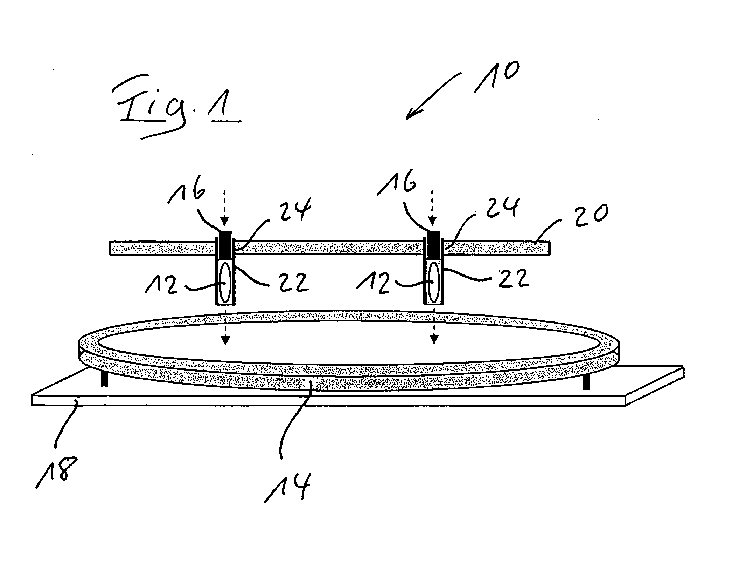

Das Schaltersystem 10 umfasst wenigstens einen Transponder 12, wenigstens eine Lesespule 14 und ein mit der Lesespule 14 verbundenes elektronisches Steuergerät (nicht gezeigt). In der Fig. 1 sind beispielsweise zwei einer Lesespule 14 zugeordnete Transponder 12 zu erkennen.

Die Transponder 12 sind jeweils über ein zugeordnetes Betätigungselement 16 in den Bereich der Lesespule 14 bewegbar. Bei in den Bereich der Lesespule 14 bewegten Transpondern 12 werden von diesen ausgesandte Daten über die Lesespule 14 vom Steuergerät empfangen, um über das Steuergerät in Abhängigkeit von den empfangenen Daten wenigstens ein Steuer- und/oder Regelsignal zu erzeugen.

Wie anhand der einzigen Figur zu erkennen ist, kann die Lesespule insbesondere auf einer Leiterplatte 18 angeordnet oder angebracht sein.

Einem jeweiligen Transponder 12 ist eine ihm eigene Kennung zugeordnet, die über die Lesespule 14 vom Steuergerät auslesbar ist. Über das Steuergerät ist dann auf den Empfang der Kennung hin ein zugeordnetes Steuer- bzw. Regelsignal erzeugbar.

Sind mehrere Transponder 12 vorgesehen, so können diesen unterschiedliche Kennungen zugeordnet sein. Über das Steuergerät können dann je nach empfangener Kennung unterschiedliche Steuer- bzw. Regelsignale erzeugt werden.

Über ein jeweiliges durch das Steuergerät erzeugte Steuer- bzw. Regelsignal kann beispielsweise eine betreffende Schaltfunktion ausgelöst bzw. wieder aufgehoben werden.

Sind mehrere Transponder 12 vorgesehen, denen unterschiedliche Kennungen zugeordnet sind, so können über das Steuergerät also je nach empfangener Kennung unterschiedliche Schaltfunktionen ausgelöst bzw. aufgehoben werden.

Wie anhand der einzigen Figur zu erkennen ist, können die Betätigungselemente 16 an einem Träger 20 verstellbar, insbesondere verschiebbar gelagert sein. Dabei sind diese Betätigungselemente 16 vorzugsweise so verstellbar, dass sie in den Bereich der Lesespule 14 bewegbar bzw. wieder aus dem Bereich der Lesespule 14 herausbewegbar sind.

Die Betätigungselemente 16 können beispielsweise einen insbesondere aus Kunststoff bestehenden Stößel umfassen. Dabei kann ein jeweiliger Transponder insbesondere in dem zugeordneten Stößel angeordnet sein.

Wie anhand der einzigen Figur zu erkennen ist, können die insbesondere jeweils durch einen Stößel gebildeten Betätigungselemente 16 beispielsweise in Lagerhülsen 22 verschiebbar angeordnet sein, die in im Träger 20 vorgesehene Durchgangsöffnungen 24 eingesetzt sind.

Der Träger 20 kann parallel zur Leiterplatte 18 angeordnet sein. Die Betätigungselemente 16 mit jeweils zugeordnetem Transponder 12 sind in diesem Fall senkrecht zum Träger 20 zur auf der Leiterplatte 18 angeordneten Lesespule 14 hin bzw. von dieser wegbewegbar.

Die Lesespule 14 kann z.B. über die Leiterplatte 18 mit dem Steuergerät verbunden sein.

Das Steuergerät kann insbesondere einen Mikrocontroller oder dergleichen umfassen.

Wie anhand der einzigen Figur zu erkennen ist, können einer jeweiligen Lesespule 14 mehrere Transponder 12 mit jeweils zugeordnetem Betätigungselement 16 zugeordnet sein. Grundsätzlich sind jedoch auch solche Ausführungen denkbar, bei denen einer jeweiligen Lesespule 14 jeweils nur ein Transponder 12 mit zugeordnetem Betätigungselement 16 zugeordnet ist.

Es können beispielsweise auch mehrere Lesespulen 14 vorgesehen sein, denen jeweils wenigstens ein Transponder 12 mit zugeordnetem Betätigungselement 16 zugeordnet ist.

Bei den Transpondern 12 handelt es sich vorzugsweise um passive Transponder ohne eigene Stromversorgung, die insbesondere über die Lesespule 14 mit Energie versorgt werden. Grundsätzlich ist jedoch auch der Einsatz aktiver Transponder mit eigener Stromversorgung denkbar.

Beim Einbringen eines jeweiligen Transponders 12 in den Bereich der Lesespule 14 kann beispielsweise ein durch die Lesespule 14 erzeugtes elektromagnetisches Feld durch den Transponder 12 entsprechend moduliert werden. Grundsätzlich ist jedoch beispielsweise auch eine solche Ausführung denkbar, bei der ein durch einen jeweiligen Transponder 12 in der Lesespule 14 induziertes Signal unmittelbar ausgewertet wird.

Die Erfindung ist mit besonderem Vorteil insbesondere in einem Fahrzeug, und hier vorteilhafterweise in Verbindung mit einem elektronischen Dachmodul oder einer Mittelkonsole des Fahrzeugs verwendbar.

### Bezugszeichenliste

- 10: Schaltersystem
- 12: Transponder
- 14: Lesespule
- 16: Betätigungselement
- 18: Leiterplatte
- 20: Träger
- 22: Lagerhülse
- 24: Durchgangsöffnung

## Patentansprüche

1. Schaltersystem (10) insbesondere für Fahrzeuge, mit wenigstens einem Transponder (12), wenigstens einer Lesespule (14) und einem mit der Lesespule (14) verbundenen elektronischen Steuergerät, wobei der Transponder (12) über ein zugeordnetes Betätigungselement (16) in den Bereich der Lesespule (14) bewegbar ist und bei in den Bereich der Lesespule (14) bewegtem Transponder (12) von diesem ausgesandte Daten über die Lesespule (14) vom Steuergerät empfangen werden, um über das Steuergerät in Abhängigkeit von den empfangenen Daten wenigstens ein Steuer- und/oder Regelsignal zu erzeugen.

2. Schaltersystem nach Anspruch 1,
**dadurch gekennzeichnet,**
**dass** einem jeweiligen Transponder (12) eine ihm eigene Kennung zugeordnet ist, die über die Lesespule (14) vom Steuergerät auslesbar ist, und dass über das Steuergerät auf den Empfang der Kennung hin ein zugeordnetes Steuer- bzw. Regelsignal erzeugbar ist.

3. Schaltersystem nach Anspruch 1 oder 2,
**dadurch gekennzeichnet,**
**dass** mehrere Transponder (12) vorgesehen sind, denen unterschiedliche Kennungen zugeordnet sind und dass über das Steuergerät je nach empfangener Kennung unterschiedliche Steuer- bzw. Regelsignale erzeugbar sind.

4. Schaltersystem nach einem der vorhergehenden Ansprüche,
**dadurch gekennzeichnet,**
**dass** über ein jeweiliges durch das Steuergerät erzeugtes Steuer- bzw. Regelsignal eine betreffende Schaltfunktion auslösbar oder aufhebbar ist.

5. Schaltersystem nach Anspruch 4,
**dadurch gekennzeichnet,**
**dass** mehrere Transponder (12) vorgesehen sind, denen unterschiedliche Kennungen zugeordnet sind, und dass über das Steuergerät je nach empfangener Kennung unterschiedliche Schaltfunktionen auslösbar bzw. aufhebbar sind.

6. Schaltersystem nach einem der vorhergehenden Ansprüche,
**dadurch gekennzeichnet,**
**dass** das Betätigungselement (16) an einem Träger (20) verstellbar, insbesondere verschiebbar gelagert ist.

7. Schaltersystem nach einem der vorhergehenden Ansprüche,
**dadurch gekennzeichnet,**
**dass** das Betätigungselement (16) einen insbesondere aus Kunststoff bestehenden Stößel umfasst.

8. Schaltersystem nach Anspruch 7,
**dadurch gekennzeichnet,**
**dass** der Transponder (12) in dem zugeordneten Stößel angeordnet ist.

9. Schaltersystem nach einem der vorhergehenden Ansprüche,
**dadurch gekennzeichnet,**
**dass** die Lesespule (14) auf einer mit dem Steuergerät verbundenen Leiterplatte (18) angeordnet ist.

10. Schaltersystem nach einem der vorhergehenden Ansprüche,
**dadurch gekennzeichnet,**
**dass** das Steuergerät einen Mikrocontroller umfasst.

11. Schaltersystem nach einem der vorhergehenden Ansprüche,
**dadurch gekennzeichnet,**
**dass** einer jeweiligen Lesespule (14) mehrere Transponder (12) mit jeweils zugeordnetem Betätigungselement (16) zugeordnet sind.

12. Schaltersystem nach einem der vorhergehenden Ansprüche,
**dadurch gekennzeichnet,**
**dass** mehrere Lesespulen (14) vorgesehen sind, denen jeweils wenigstens ein Transponder (12) mit zugeordnetem Betätigungselement (16) zugeordnet ist.

13. Schaltersystem nach einem der vorhergehenden Ansprüche,
**dadurch gekennzeichnet,**
**dass** wenigstens ein passiver Transponder (12) vorgesehen ist.

14. Schaltersystem nach einem der vorhergehenden Ansprüche,
**dadurch gekennzeichnet,**
**dass** wenigstens ein aktiver Transponder (12) vorgesehen ist.

15. Verwendung des Schaltersystems nach einem der vorhergehenden Ansprüche in einem Fahrzeug, insbesondere in Verbindung mit einem elektronischen Dachmodul oder einer Mittelkonsole des Fahrzeugs.

## Geänderte Patentansprüche

### Geänderte Patentansprüche gemäss Regel 137(2) EPÜ.

**1.** Schaltersystem (10) insbesondere für Fahrzeuge, mit wenigstens einem Transponder (12), wenigstens einer Lesespule (14) und einem mit der Lesespule (14) verbundenen elektronischen Steuergerät, wobei der Transponder (12) über ein zugeordnetes Betätigungselement (16) in den Bereich der Lesespule (14) bewegbar ist und bei in den Bereich der Lesespule (14) bewegtem Transponder (12) von diesem ausgesandte Daten über die Lesespule (14) vom Steuergerät empfangen werden, um über das Steuergerät in Abhängigkeit von den empfangenen Daten wenigstens ein Steuer- und/oder Regelsignal zu erzeugen,
**dadurch gekennzeichnet,**
**dass** über ein jeweiliges durch das Steuergerät erzeugtes Steuer- bzw. Regelsignal eine betreffende Schaltfunktion auslösbar oder aufhebbar ist.

**2.** Schaltersystem nach Anspruch 1,
**dadurch gekennzeichnet,**
**dass** einem jeweiligen Transponder (12) eine ihm eigene Kennung zugeordnet ist, die über die Lesespule (14) vom Steuergerät auslesbar ist, und dass über das Steuergerät auf den Empfang der Kennung hin ein zugeordnetes Steuer- bzw. Regelsignal erzeugbar ist.

**3.** Schaltersystem nach Anspruch 1 oder 2,
**dadurch gekennzeichnet,**
**dass** mehrere Transponder (12) vorgesehen sind, denen unterschiedliche Kennungen zugeordnet sind und dass über das Steuergerät je nach empfangener Kennung unterschiedliche Steuer- bzw. Regelsignale erzeugbar sind.

**4.** Schaltersystem nach einem der vorhergehenden Ansprüche,
**dadurch gekennzeichnet,**
**dass** mehrere Transponder (12) vorgesehen sind, denen unterschiedliche Kennungen zugeordnet sind, und dass über das Steuergerät je nach empfangener Kennung unterschiedliche Schaltfunktionen auslösbar bzw. aufhebbar sind.

**5.** Schaltersystem nach einem der vorhergehenden Ansprüche,
**dadurch gekennzeichnet,**
**dass** das Betätigungselement (16) an einem Träger (20) verstellbar, insbesondere verschiebbar gelagert ist.

**6.** Schaltersystem nach einem der vorhergehenden Ansprüche,
**dadurch gekennzeichnet,**
**dass** das Betätigungselement (16) einen insbesondere aus Kunststoff bestehenden Stößel umfasst.

**7.** Schaltersystem nach Anspruch 6,
**dadurch gekennzeichnet,**
**dass** der Transponder (12) in dem zugeordneten Stößel angeordnet ist.

**8.** Schaltersystem nach einem der vorhergehenden Ansprüche,
**dadurch gekennzeichnet,**
**dass** die Lesespule (14) auf einer mit dem Steuergerät verbundenen Leiterplatte (18) angeordnet ist.

**9.** Schaltersystem nach einem der vorhergehenden Ansprüche,
**dadurch gekennzeichnet,**
**dass** das Steuergerät einen Mikrocontroller umfasst.

**10.** Schaltersystem nach einem der vorhergehenden Ansprüche,
**dadurch gekennzeichnet,**
**dass** einer jeweiligen Lesespule (14) mehrere Transponder (12) mit jeweils zugeordnetem Betätigungselement (16) zugeordnet sind.

**11.** Schaltersystem nach einem der vorhergehenden Ansprüche,
**dadurch gekennzeichnet,**
**dass** mehrere Lesespulen (14) vorgesehen sind, denen jeweils wenigstens ein Transponder (12) mit zugeordnetem Betätigungselement (16) zugeordnet ist.

**12.** Schaltersystem nach einem der vorhergehenden Ansprüche,
**dadurch gekennzeichnet,**
**dass** wenigstens ein passiver Transponder (12) vorgesehen ist.

**13.** Schaltersystem nach einem der vorhergehenden Ansprüche,
**dadurch gekennzeichnet,**
**dass** wenigstens ein aktiver Transponder (12) vorgesehen ist.

**14.** Verwendung des Schaltersystems nach einem der vorhergehenden Ansprüche in einem Fahrzeug, insbesondere in Verbindung mit einem elektronischen Dachmodul oder einer Mittelkonsole des Fahrzeugs.
